# EUROPEAN PATENT SPECIFICATION

(11) **EP 2 266 134 B1**
(45) Date of publication and mention of the grant of the patent: **08.05.2013**
(21) Application number: 09722100.6
(22) Date of filing: 16.03.2009
(51) Int. Cl.: H01L 21/768, H01L 21/3213, B23K 26/40, B23K 26/06

(54) **PROCESSING OF MULTILAYER SEMICONDUCTOR WAFERS**
VERARBEITEN VON MEHRSCHICHTIGEN HALBLEITERWAFERN
TRAITEMENT DE TRANCHES SEMI-CONDUCTRICES MULTICOUCHES

(30) Priority: 18.03.2008 GB 0805037
(43) Date of publication of application: 29.12.2010
(73) Proprietor: Electro Scientific Industries, Inc., Portland, OR 97229-5497 (US)
(72) Inventor: RODIN, Aleksej, 2001 Vilnius (LT); BOYLE, Adrian, Co. Kildare (IE); BRENNAN, Niall, Dublin 11 (IE); CALLAGHAN, Joseph, Dublin 1 (IE)
(74) Representative: Want, Clifford James
(86) International application number: PCT/EP2009/053061
(87) International publication number: WO 2009/115484

(56) References cited:
- EP-A- 1 201 108
- EP-A- 1 328 372
- EP-B- 1 404 481
- WO-A-2006/048230
- WO-A-2006/063153
- WO-A-2007/088058
- US-A1- 2005 087 522
- US-A1- 2005 274 702

## Description

This invention relates to processing multilayer semiconductor wafers.

A semiconductor wafer typically includes a number of layers of metals and insulators on a surface which are used to define active circuitry of devices produced from the wafer. With developing wafer technology, these layers present problems in processes subsequent to their formation that are necessary to create the active devices from the wafer.

The problems are caused mainly by new materials used in the surface layers and a requirement for smaller feature sizes for lower costs, thinner wafers and smaller devices. Specific processes which are problematic are wafer dicing, which traditionally involves using an abrasive saw to cut the wafer into individual die, and an interconnect formation process which traditionally has used wired bonded from one region to a next to form a wire bond interconnect. A competing approach to the wire bond is to drill interconnecting vias between opposed faces of a wafer and to form interconnects on the underside of the resulting device or on to another device. This technology is termed "through via" technology. In a similar way, blind vias allow electrical contact with an internal layer of the wafer. These processes are used as part of what is known as "via last" processing, in which an interconnecting via is drilled on manufactured wafers.

While known etch techniques can provide a solution, at least in via drilling to these processing problems, the cost is generally high because of technical obstacles such as particularly low throughput, via geometry and material sensitivity. Briefly, the via taper angle typically required is not perfectly straight and this is difficult to achieve by etching but is possible with laser drilling. Also, where metals and insulators are stacked, different etch processes are often required for each and these processes are slow.

WO 2006/063153 discloses a method of using a first wavelength to machine through a passivation layer overlying a link and a second wavelength, which will not substantially damage an underlying passivation layer or substrate, to machine through the link. Typically the first wavelength (UV or green) is shorter than the second wavelength (visible in IR). The two wavelengths are combined in a single pulse.

US 2005/087522 discloses laser ablation comprising heating a substrate with a light beam before applying a laser beam to the heated substrate to increase the laser ablation rate particularly for via production and laser dicing. The heating is preferably performed with a continuous wave and laser ablation with a pulsed laser. In one embodiment a mode-locked IR laser has pulse widths in the range 0.01-1000 ps.

It is an object of the present invention at least to ameliorate the aforesaid deficiencies in the prior art.

According to the invention, there is provided a method of machining, or forming a feature in, a patterned silicon wafer according to claim 1.

Conveniently, the method further comprises removing re-deposited silicon from the wafer by etching.

Advantageously, the second pulsed laser beam is produced by a Q-switched laser with a pulse width in the range 1ns to 500ns

Alternatively, the second pulsed laser beam has a pulse width between 1ps and 1000ps.

Conveniently, the method comprises etching with xenon difluoride.

Conveniently, the method comprises a wet chemical etch.

Alternatively, the method comprises a dry chemical etch.

Advantageously, the etch process is used to clear at least one of the surface of the wafer and the machined walls of the wafer of debris.

Advantageously the method comprises forming an interconnecting through via or blind via in the wafer.

Alternatively, the method comprises dicing or singulating a wafer.

The invention will now be described, by way of example, with reference to the accompanying drawings in which:
Figure 1 is a schematic diagram of an apparatus according to the invention;
Figures 2A and 2B are flowcharts of methods according to embodiments of the invention;
Figures 3 to 6 are optical micrographs of a plan view of surface layers drilled for a via with a picosecond pulse laser;
Figures 7 to 12 are scanning electron micrographs of plan, side and tilted views of surface layers drilled with a picosecond pulse laser for a via;
Figure 13 is a scanning electron micrograph in backscattering mode of surface layers drilled with a picosecond pulse laser for a via;
Figures 14 and 15 are scanning electron micrographs of plan and tilted views respectively of a via after a second step of the method of the invention of laser drilling a substrate of the wafer;
Figures 16 and 17 are scanning electron micrographs in backscatter mode of a via after the second step of the method of the invention;
Figure 18 is an electron scanning micrograph of a via profile after the second step of the method of the invention;
Figure 19 is an electron scanning micrograph in backscatter mode of the via profile after a second step of the method of the invention;
Figures 20 and 21 are scanning electron micrographs of an etching process of the invention, showing a side wall;
Figure 22 is a scanning electron micrograph of the etching process of the invention, in scattered light showing a side wall; and
Figure 23 is a scanning electron micrograph showing silicon droplets partially removed and clean metal layers.

In the Figures, like reference numerals denote like parts.

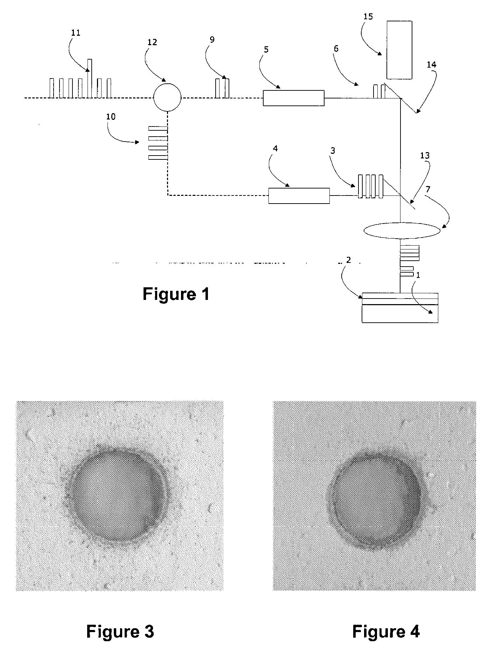

Referring to Figure 1, in an apparatus according to the invention, first and second lasers 4, 5 provide parallel laser beams. A laser beam from the first laser 5 is incident on a folding mirror 14 to deflect the laser beam through 90 deg. in a direction towards the laser beam from the first laser. Both laser beams are thereby incident mutually orthogonally on a beam splitter 13 which deflects the laser beam from the second laser 4 through 90 deg. in a direction away from the laser beam from the first laser 5 so that the two beam paths are alternately coaxially incident on a collimating lens 7 which focuses the laser beams onto a wafer having a substrate 1 and surface layers 2.

The first and second lasers are controlled by respective signal pulses 9, 10. A switch 12 is provided to switch a train of signal pulses from a source, not shown, between the first and second lasers. The switch 12 is controlled by a trigger pulse 11 in the train of pulses switched by the switch 12 to the first laser 5 or the second laser 4.

Thus the apparatus is used to perform a process on a semiconductor wafer by delivering respective laser beams to a same location on the wafer 1, 2. It will be understood that there are a number of approaches that may be used to achieve this. In the approach illustrated in Figure 1, both lasers beams are propagated collinearly as illustrated following beam path combination in the beam splitter 13. Where the laser beams have different wavelengths the beam splitter may be transparent to a first laser beam from laser 5 and reflective to a second laser beam from laser 4. Alternatively, one skilled in the art will recognise that polarisation or other means of beam combination may be used. This requires careful design of optical parameters in each beam path. The beams may be delivered though a standard lens 7 which may be a compound lens designed to provide a required beam diameter at a focus of each beam. One skilled in the art will realise that wafer positioning may be achieved through use of known and well-established machine vision systems and wafer or beam motion systems so that the laser beams are alternately incident at a required location on the wafer. In the example illustrated in Figure 1 a machine vision camera 15 is collinear with the beam splitter 13 and a folding mirror 14 to allow imaging of the machining scene and the wafer before, during and after machining.

Figure 1 shows a typical configuration. Pulse emission from each laser can be synchronised to ensure that transitions from sequential exposure of surface layers to subsequent bulk silicon are instantaneous and in a correct sequence. One such embodiment utilises an electrical circuit as shown in Figure 1 by which the train of signal pulses 9 is provided to the first laser 5 in order to provide laser beam pulses 6 for drilling the layered structure 2. Once a sufficient number of pulses have been delivered the circuit switches to deliver a train of signal pulses 10 to the second laser 4 using a larger switching or other trigger signal pulse 11 to switch a suitable electrical switch 12. This second laser 4 then emits laser beam pulses 3 for drilling the bulk silicon 1. One skilled in the art will recognise that there are many mechanism to control pulse emissions from the lasers and this invention is not limited to the one described.

Alternatively the laser beams may be displaced with respect to each other. One skilled in the art will recognise that in effect this process requires a known laser placement process applied to each laser using known methods of machine vision and wafer placement mentioned previously.

In a method according to the invention, problems which are associated with known etch processes are overcome by using a series of laser drilling or machining steps to perform the required operations. The process steps may be applied for drilling via interconnects and/or for scribing and dicing silicon wafers.

To understand the processes it is necessary to consider the lasers which are used. Known nanosecond lasers such as ultraviolet Q-switched lasers as described in EP 1201108, EP 1328372, EP 1404481, EP 1825507 and WO 2007/088058 can be used in via formation, scribing or dicing. However, in some cases layers of metals and insulators on the wafer surface are damaged excessively using these nanosecond pulse lasers alone.

Accordingly a laser with a pulse width between 1 picosecond (ps) and 1000 ps is used to remove or drill through metals and insulators on a surface of a wafer without inducing collateral damage. A layer stack is removed or drilled according to the invention using a short pulse laser.

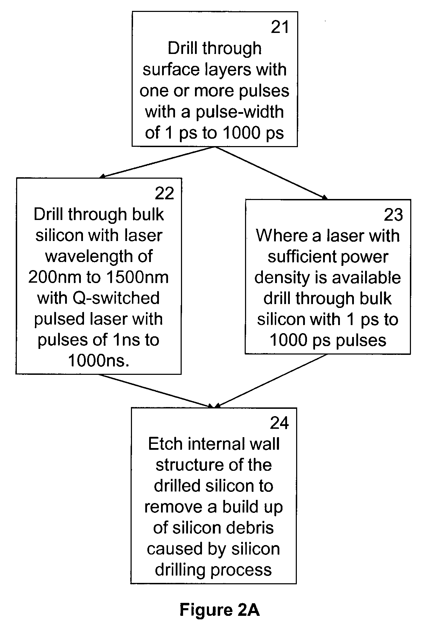

Referring to Figures 1 and 2A, the full laser process therefore involves the following:
Step 1: Drilling 21 through a layered medium 2 comprising one or more layers on a surface of a wafer using a first laser 5 with one or more laser pulses 6 with a pulse-width between 1 ps and 1000 ps.
Step 2: Drilling 22 through the bulk silicon wafer 2 using a Q-switched pulsed laser 4 with a wavelength between 200 nm and 1500 nm and pulses 3 which are between 1ns and 1000 ns. Alternatively, where a laser with sufficient power density is available to achieve a desired throughput, drilling 23 may be performed with a short pulse laser similar to the picosecond pulse laser used in surface layer removal or drilling.
Step 3: Etching 24 the wall structure of the drilled or machined silicon to remove a build up of silicon debris caused by the silicon drilling process.

### Example: Result of the first step of the process: cutting through active layers by picosecond pulse laser beam

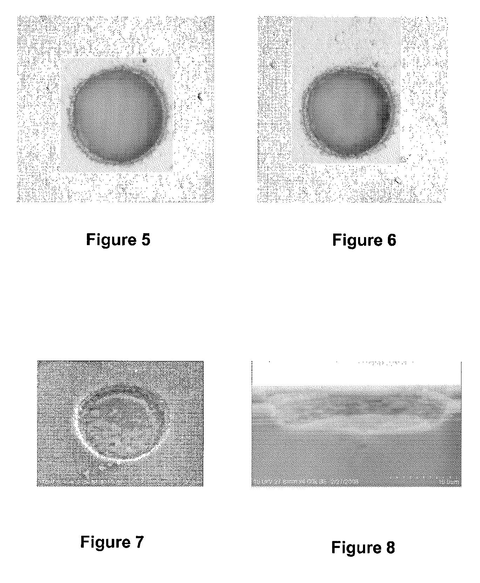

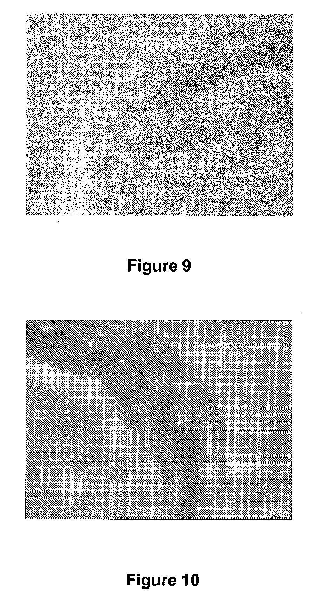

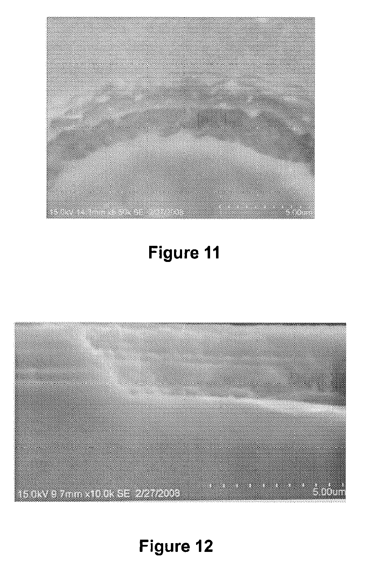

Optical microscope images of surface layers drilled for vias with the ps laser alone are shown in Figures 3 to 6. Active layers that have been exposed are sharp and layers are well-distinguished as observed on SEM-images shown in Figures 7 to 13. In addition, particles and debris on the surface are minimal.

### Result of the second step of the process: intra volume Si laser drilling

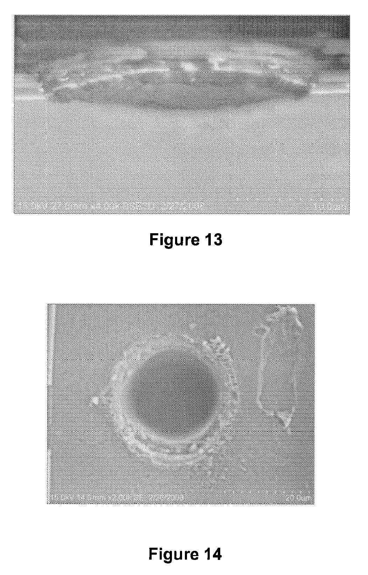

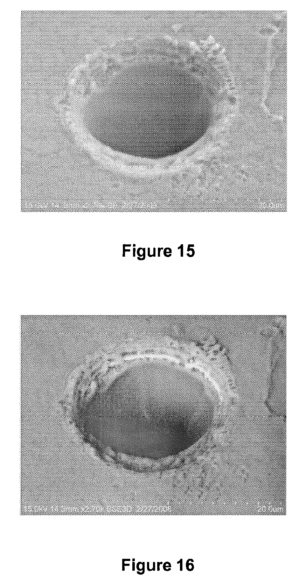

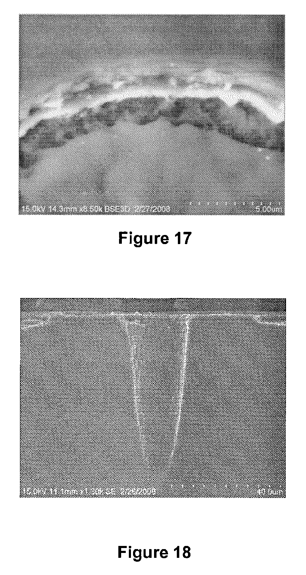

60-70 µm deep vias of ∼24 µm diameter are drilled intra volume after manual alignment with vias of ∼28 µm diameter machined earlier by picosecond pulse laser in the active layers. Figures 14 to 19 show SEM images of the resulting vias.

From the cross-sectional and the angled views obtained from the SEM it is evident the picosecond laser alone drills cleanly through the structured layers, leaving each intact and well defined. When a nanosecond pulse laser is subsequently used to drill the silicon substrate the active layers become coated with recast silicon.

Without using the picosecond laser pulses, typically the inside of the via includes metal particles. Using the picosecond pulse laser to drill the active layers, no metal is present in the vias. Using an etchant which reacts with silicon but not metal, re-deposited silicon may be etched without masking since the majority of the wafer's surface is metal and polyimide forming a self-aligned mask for etching inner walls of the vias.

### Result of a third step of the process: etching.

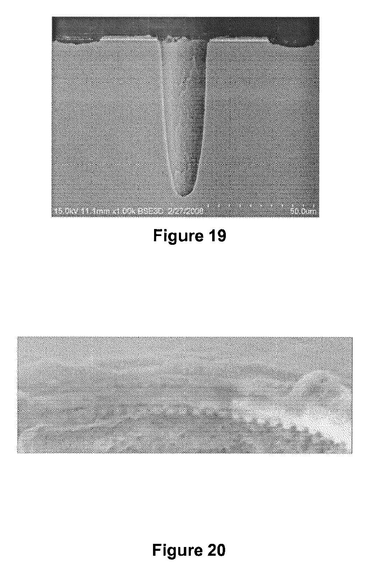

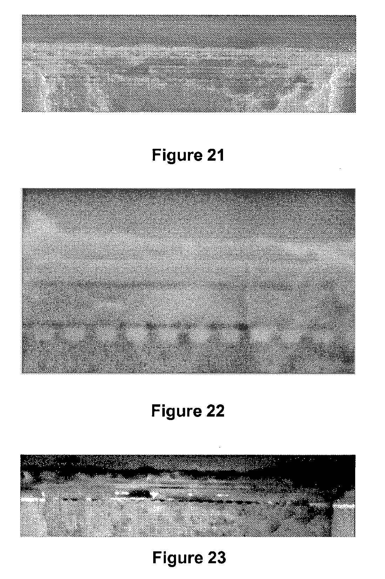

Referring to Figures 20 to 23, to remove adhered silicon debris around the multilayer stack, the samples are subjected to a short XeF₂ etch cycle, successful results of which can be seen in the Figures.

The invention is not limited to the use of XeF₂ as the etchant. Other etchants such as "noble halogens" or "inter-halides" in either liquid or gas form may alternatively be used. Wet chemical etch using KOH, tetramethylammonium hydroxide (TmaH) or other chemicals known to one skilled in the art may alternatively be used selectively to remove silicon. Finally, plasma etching and reactive ion etching may alternatively be used to perform the final step.

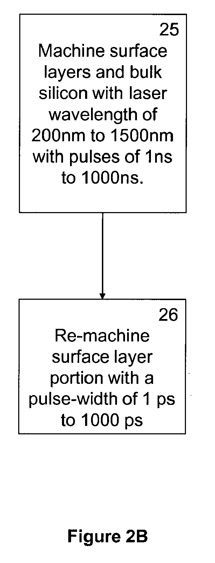

Referring to Figure 2B, in another embodiment of the invention, a similar result may be achieved by reversing the order of picosecond pulse laser and bulk silicon nanosecond pulse laser. To achieve the same effect in this instance, layers on the surface are machined 25 coarsely by the bulk silicon laser as part of the bulk silicon machining process. Following this process the metal and insulator layers are exposed to the picosecond laser with a beam profile such that machining 26 of the metal layers is performed to widen the via aperture at the metal and insulator layers and to provide a similar clean cut and finish as in the case where the metal insulator layers are machined first.

## Claims

1. A method of machining, or forming a feature in, a patterned silicon wafer comprising:
a. removing (21) portions of surface layers on the wafer using a first pulsed laser beam (6) from a first laser (4), the first pulsed laser beam having a pulse width between 1ps and 1000ps, wherein the first pulsed laser beam (6) has a wavelength between 1000nm and 1100nm; and
b. subsequently removing (22) portions of bulk silicon underlying the surface layers from the wafer using a second pulsed laser beam (3) from a second laser (5), the second pulsed laser beam having a wavelength between 200nm and 1100nm;
c. wherein the first pulsed laser beam and the second pulsed laser beam are delivered to a same location on the silicon wafer.

2. A method as claimed in claim 1 comprising removing (24) re-deposited silicon from the wafer by etching.

3. A method as claimed in claims 1 or 2, wherein the second pulsed laser beam (3) is produced by a Q-switched laser with a pulse width in the range 1ns to 500ns and wherein alternatively the second pulsed laser beam (3) has a pulse width between 1ps and 1000ps.

4. A method as claimed in any of claims 2 to 3, comprising etching (24) with xenon difluoride.

5. A method as claimed in any of claims 2 to 3, comprising a wet or dry chemical etch.

6. A method as claimed in any of claims 2 to 5 where the etch process is used to clear at least one of the surface of the wafer and the machined walls of the wafer of debris.

7. A method as claimed in any of the preceding claims, comprising forming an interconnecting through via or blind via in the wafer or comprising dicing or singulating a wafer.

## Patentansprüche

1. Verfahren zur Bearbeitung oder Ausbildung eines Merkmals in einem strukturierten Siliziumwafer, wobei das Verfahren folgendes umfasst:
a) das Entfernen (21) von Abschnitten von Oberflächenschichten auf dem Wafer unter Verwendung eines ersten Impulslaserstrahls (6) von einem ersten Laser (4), wobei der erste Impulslaserstrahl eine Impulsbreite zwischen 1 ps und 1000 ps aufweist, wobei der erste Impulslaserstrahl (6) eine Wellenlänge zwischen 1000 nm und 1100 nm aufweist; und
b) das folgende Entfernen (22) von Abschnitten von Siliziumgrundmaterial, das unter den Oberflächenschichten liegt, von dem Wafer unter Verwendung eines zweiten Impulslaserstrahls (3) von einem zweiten Laser (5), wobei der zweite Impulslaserstrahl eine Wellenlänge zwischen 200 nm und 1100 nm aufweist;
c) wobei der erste Impulslaserstrahl und der zweite Impulslaserstrahl an eine gleiche Stelle auf dem Siliziumwafer zugeführt werden.

2. Verfahren nach Anspruch 1, wobei dieses das Entfernen (24) des erneut abgeschiedenen Siliziums durch Ätzen von dem Wafer umfasst.

3. Verfahren nach einem der Ansprüche 1 oder 2, wobei der zweite Impulslaserstrahl (3) durch einen Q-Switch-Laser mit einer Impulsbreite im Bereich von 1 ns bis 500 ns erzeugt wird, und wobei alternativ der zweite Impulslaserstrahl (3) eine Impulsbreite zwischen 1 ps und 1000 ps aufweist.

4. Verfahren nach einem der Ansprühe 2 bis 3, wobei das Verfahren das Ätzen (24) mit Xenondifluorid umfasst.

5. Verfahren nach einem der Ansprüche 2 bis 3, wobei das Verfahren ein Nass- oder Trockenätzverfahren umfasst.

6. Verfahren nach einem der Ansprüche 2 bis 5, wobei das Ätzverfahren eingesetzt wird, um zumindest die Oberfläche des Wafers oder die bearbeiteten Wände des Wafers von Rückständen zu reinigen.

7. Verfahren nach einem der vorstehenden Ansprüche, wobei das Verfahren das Ausbilden einer Zwischenverbindungs-Durchkontaktierung oder eines Sacklochs in dem Wafer oder das Zerteilen oder Zertrennen eines Wafers umfasst.

## Revendications

1. Procédé d'usinage de, ou de formation d'une caractéristique dans, une tranche de silicium à motifs comprenant les étapes consistant à :
a. enlever (21) des portions de couches de surface sur la tranche en utilisant un premier faisceau laser pulsé (6) à partir d'un premier laser (4), le premier faisceau laser pulsé ayant une largeur d'impulsion comprise entre 1 ps et 1 000 ps, dans lequel le premier faisceau laser pulsé (6) a une longueur d'onde comprise entre 1 000 nm et 1 100 nm ; et
b. enlever subséquemment (22) des portions de silicium en vrac sous-jacent aux couches de surface de la tranche en utilisant un second faisceau laser pulsé (3) à partir d'un second laser (5), le second faisceau laser pulsé ayant une longueur d'onde comprise entre 200 nm et 1 100 nm ;
c. dans lequel le premier faisceau laser pulsé et le second faisceau laser pulsé sont administrés à un même emplacement sur la tranche de silicium.

2. Procédé selon la revendication 1, comprenant l'étape consistant à enlever (24) le silicium redéposé de la tranche par attaque chimique.

3. Procédé selon la revendication 1 ou 2, dans lequel le second faisceau laser pulsé (3) est produit par un laser déclenché avec une largeur d'impulsion dans la plage comprise entre 1 ns et 500 ns et dans lequel en variante, le second faisceau laser pulsé (3) a une largeur d'impulsion comprise entre 1 ps et 1 000 ps.

4. Procédé selon la revendication 2 ou 3, comprenant l'étape consistant à effectuer l'attaque chimique (24) avec du difluorure de xénon.

5. Procédé selon la revendication 2 ou 3, comprenant une attaque chimique humide ou sèche.

6. Procédé selon l'une quelconque des revendications 2 à 5, dans lequel le processus d'attaque est utilisé pour enlever les débris d'au moins lune parmi la surface de la tranche et les parois usinées de la tranche.

7. Procédé selon l'une quelconque des revendications précédentes, comprenant l'étape consistant à former une interconnexion par un trou d'interconnexion ou un trou d'interconnexion borgne dans la tranche ou comprenant l'étape consistant à découper en dés ou à singulariser une tranche.
